# EUROPEAN PATENT SPECIFICATION

(11) **EP 4 369 891 B1**
(45) Date of publication and mention of the grant of the patent: **26.11.2025**
(21) Application number: 22855996.9
(22) Date of filing: 15.06.2022
(51) Int. Cl.: H10K 59/00, G09G 3/20, H04N 23/55, H10K 59/35, H04M 1/02, G06F 1/16, H10K 59/65, H10K 59/131

(54) **ELECTRONIC DEVICE INCLUDING UDC**
ELEKTRONISCHE VORRICHTUNG MIT UDC
DISPOSITIF ÉLECTRONIQUE COMPRENANT UN UDC

(30) Priority: 11.08.2021 KR 20210106047; 18.04.2022 KR 20220047798
(43) Date of publication of application: 15.05.2024
(73) Proprietor: Samsung Electronics Co., Ltd., Suwon-si, Gyeonggi-do 16677 (KR)
(72) Inventor: WU, Yilin, Suwon-si, Gyeonggi-do 16677 (KR); SHIN, Sungyoung, Suwon-si, Gyeonggi-do 16677 (KR); UHM, Minsuk, Suwon-si, Gyeonggi-do 16677 (KR); LEE, Dongseop, Suwon-si, Gyeonggi-do 16677 (KR); LEE, Haechang, Suwon-si, Gyeonggi-do 16677 (KR); KIM, Kwangtai, Suwon-si, Gyeonggi-do 16677 (KR); YEOM, Donghyun, Suwon-si, Gyeonggi-do 16677 (KR)
(74) Representative: HGF
(86) International application number: PCT/KR2022/008498
(87) International publication number: WO 2023/017994

(56) References cited:
- CN-A- 111 010 468
- CN-A- 111 681 560
- CN-A- 112 786 645
- KR-A- 20210 060 186
- KR-A- 20210 082 316
- KR-A- 20210 094 189
- US-A1- 2022 302 221

## Description

### [Technical Field]

Various embodiments of the disclosure relate to an electronic device including a UDC.

### [Background Art]

Electronic devices, for example, portable electronic devices, are released in various sizes depending on their functions and user preferences, and may include a large-screen touch display to ensure wide visibility and convenience of operation. Electronic devices may include at least one camera. For example, electronic devices may include at least one camera disposed around the display or overlapping at least a portion of the display.
Document CN 111 010 468 A describes a display screen assembly and an electronic device, the display screen assembly including a display screen, the display screen including a first display region and a second display region.

### [Disclosure of Invention]

### [Technical Problem]

Recently, as a method to expand the display area of a display in an electronic device, under-display camera (UDC) technology in which a camera is disposed around (e.g., under) the active area of the display has been researched and developed. For example, the electronic device having a UDC disposed under the active area of a display is required to increase the transmittance in at least a partial area (hereinafter referred to as "UDC area") of the display overlapping the UDC to increase the amount of light incident on the UDC. To this end, a method may be proposed to reduce the arrangement density of pixels and/or wires of a display in the UDC area and to form a transmission area in which pixels and/or wires are not formed in the UDC area.

In the electronic device, at least some light incident on the UDC may be affected by at least some layers constituting the display. For example, light diffraction due to display pixels and/or wires arranged to overlap the UDC may deteriorate the quality of images captured through the UDC.

Various embodiments of the disclosure may provide an electronic device capable of improving the quality of images captured through the UDC by reducing diffraction in a partial area of the display disposed to overlap the UDC.

The technical problems sought to be solved in the disclosure are not limited to the technical problems mentioned above, and other technical problems not mentioned will be clearly understood by those skilled in the art to which the disclosure pertains from the description below.

### [Solution to Problem]

The invention is directed to the subject-matter of independent claim 1. Advantageous embodiments are set out in the dependent claims.

An electronic device according to various embodiments may include a housing, a display that is visible through a portion of the housing, and a camera disposed to overlap a portion of the display and configured to obtain external light passing through the display, wherein the display may include a first area overlapping at least a portion of the camera and a second area excluding the first area, wherein the first area may include a plurality of clusters and at least one or more wires electrically connecting the plurality of clusters to each other, wherein a first sub-pixel, a second sub-pixel, and a third sub-pixel may be disposed adjacent to each other to form one cluster, wherein respective boundary lines of the plurality of clusters may be tilted at specific angles with respect to a designated reference axis, and wherein the tilted angles of the respective boundary lines of the plurality of clusters may be different from each other.

A display for an under-display camera (UDC) according to various embodiments may include a first area overlapping at least a portion of the UDC and a second area excluding the first area, wherein the first area may include a plurality of clusters and at least one or more wires electrically connecting the plurality of clusters to each other, wherein a first sub-pixel, a second sub-pixel, and a third sub-pixel may be disposed adjacent to each other to form one cluster, wherein respective boundary lines of the plurality of clusters may be tilted at specific angles with respect to a designated reference axis, and wherein the tilted angles of the respective boundary lines of the plurality of clusters may be different from each other.

### [Advantageous Effects of Invention]

Electronic devices according to various embodiments of the disclosure are able to improve the quality of images captured through a UDC by reducing diffraction in a partial area of the display disposed to overlap the UDC.

In addition, various effects directly or indirectly identified through the disclosure may be provided.

### [Brief Description of Drawings]

Other aspects, features, and advantages according to specific embodiments of the disclosure will become more apparent from the accompanying drawings and descriptions corresponding thereto.
FIG. 1 is a perspective view illustrating the front of an electronic device according to various embodiments of the disclosure.
FIG. 2 is a perspective view illustrating the rear of the electronic device in FIG. 1 according to various embodiments of the disclosure.
FIG. 3 is an exploded perspective view of the electronic device in FIG. 1 according to various embodiments of the disclosure.
FIG. 4 is an exploded perspective view of a display according to various embodiments shown in FIG. 3.
FIG. 5 is a cross-sectional view illustrating a camera overlap area (e.g., a first area) of a display according to an embodiment.
FIG. 6 is a diagram illustrating an example of an enlarged camera overlap area (e.g., a first area) of a display according to an embodiment.
FIG. 7 is a diagram illustrating an example of the irregular arrangement of clusters according to an embodiment.
FIG. 8 is a diagram illustrating an example of a black mask according to an embodiment.
FIG. 9 is a diagram illustrating an example of the form of a black mask according to an embodiment.
FIG. 10 is a diagram illustrating an example of the form of a black mask according to another embodiment.
FIG. 11 is a diagram illustrating an example of directions of TFTs according to an embodiment.

### [Mode for the Invention]

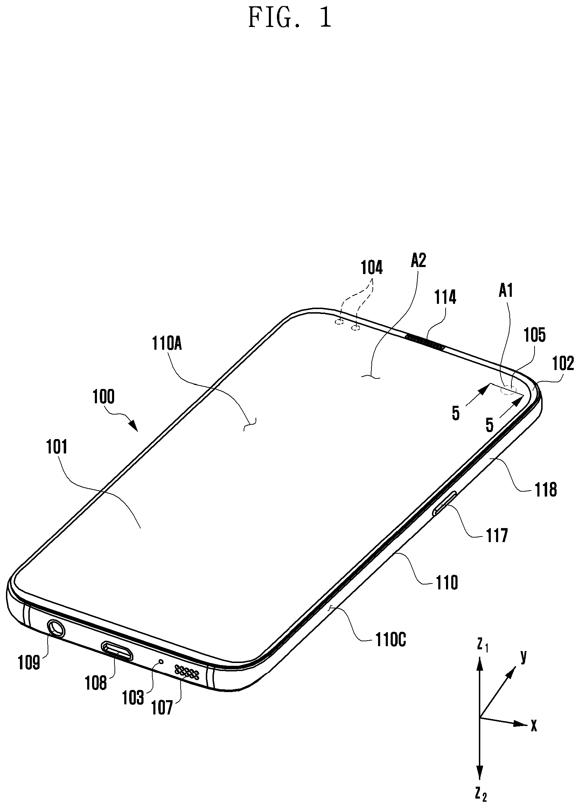

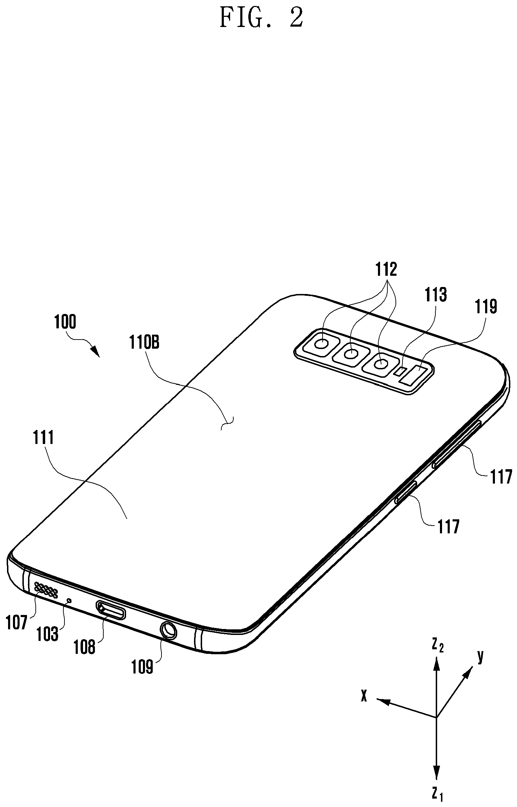

FIG. 1 is a perspective view illustrating the front of an electronic device 100 according to various embodiments of the disclosure. FIG. 2 is a perspective view illustrating the rear of the electronic device 100 in FIG. 1 according to various embodiments of the disclosure.

Referring to FIGS. 1 and 2, the electronic device 100 according to an embodiment may include a housing 110 that includes a first surface (or front surface) 110A, a second surface (or back surface) 110B, and a side surface 110C surrounding the space between the first surface 110A and the second surface 110B. In another embodiment (not shown), the housing may refer to a structure that constitutes some of the first surface 110A, the second surface 110B, and the side surface 110C in FIG. 1. According to an embodiment, the first surface 110A may be formed of a substantially transparent front plate 102 at least in part (e.g., a glass plate or a polymer plate including various coating layers). The second surface 110B may be formed of a substantially opaque rear plate 111. The rear plate 111 may be formed of, for example, coated or tinted glass, ceramic, polymer, metal (e.g., aluminum, stainless steel (STS), or magnesium), or a combination of at least two of the above materials. The side surface 110C may be coupled to the front plate 102 and the rear plate 111, and may be formed in a side bezel structure 118 (or a "side member") including metal and/or polymer. In a certain embodiment, the rear plate 111 and the side bezel structure 118 may be formed integrally and may include the same material (e.g., a metal material such as aluminum).

According to an embodiment, the electronic device 100 may include at least one of a display 101, an input device 103, sound output devices 107 and 114, sensor modules 104 and 119, cameras 105 and 112, a key input device 117, an indicator (not shown), and connectors 108 and 109. In a certain embodiment, the electronic device 100 may exclude at least one (e.g., the key input device 117, the connectors 108, 109, or the indicator) of the elements or may further include other elements.

According to an embodiment, the display 101 may be visible through, for example, a portion of the front plate 102. In a certain embodiment, at least a portion of the display 101 may be visible through the front plate 102 constituting the first surface 110A. In a certain embodiment, the edges of the display 101 may be formed to be substantially the same as the adjacent outer shape of the front plate 102. In another embodiment (not shown), in order to expand the area where the display 101 is exposed, the distance between the outer edge of the display 101 and the outer edge of the front plate 102 may be formed to be substantially the same.

According to an embodiment, the surface (or the front plate 102) of the housing 110 may include a screen display area formed as the display 101 is visually exposed. According to an embodiment, the screen display area may include a camera overlap area A1 (e.g., the first area) where a first camera 105 is disposed under the same (e.g., in the z2 direction) and a normal display area A2 (e.g., the second area) where a camera is not disposed under the same (e.g., in the z2 direction). According to another embodiment, the screen display area may further include a sensor overlap area (not shown) in which at least one sensor module (not shown) is disposed under the same (e.g., in the z2 direction). For example, at least one sensor module may be a variety of sensors that operate by acquiring external light.

According to an embodiment, the cameras 105 and 112 may include a first camera 105 disposed on the first surface 110A of the electronic device 100 and/or a second camera 112 disposed on the second surface 110B. The cameras 105 and 112 may include one or more lenses, an image sensor, and/or an image signal processor. The cameras 105 and 112 may further include a flash 113. In a certain embodiment, two or more lenses (wide-angle lens, ultra-wide-angle lens, or telephoto lens) and image sensors may be disposed on the first surface 110A or the second surface 110B of the electronic device 100. In an embodiment, the electronic device 100 may include a plurality of cameras 105 and 112. For example, the electronic device 100 may include a plurality of cameras (e.g., a dual camera or a triple camera) having different properties (e.g., angle of view) or functions from each other. For example, a plurality of cameras 105 and 112 including lenses having different angles of view may be configured, and the electronic device 100 may perform control to change the angle of view of the camera 105 or 112 operated in the electronic device 100, based on the user's selection. Additionally, the plurality of cameras 105 and 112 may include at least one of a wide-angle camera, a telephoto camera, a color camera, a monochrome camera, or an infrared (IR) camera (e.g., a time-of-flight (TOF) camera or a structured light camera). According to an embodiment, the IR camera may operate as at least a part of the sensor module.

According to an embodiment, the first camera 105 may be disposed under the camera overlap area A1 of the display (e.g., in the z2 direction). The first camera 105 may be named an under-display camera (UDC). For example, since the first camera 105 is disposed under the camera overlap area A1 of the display (e.g., in the z2 direction), the position of the first camera 105 may not be visually distinguished (or exposed). According to an embodiment, when the display 101 is viewed from the front (e.g., in the z1 direction), the first camera 105 may be disposed in the camera overlap area A1, which is at least a portion of the display, and may obtain images of external subjects while not visually exposed to the outside. For example, when viewed from the front (e.g., in the z1 direction) of the display 101, the first camera 105 may be disposed to overlap at least a portion of the camera overlap area A and may obtain images of external subjects without being visually exposed.

According to an embodiment, a recess or an opening may be formed in a portion of the screen display area (e.g., the first surface 110A or the first area 110D) of the display 101, and at least one or more of the sound output device 114, the sensor module 104, a light-emitting device (e.g., a flash), and the camera 105 may be provided to be at least partially aligned with the recess or opening. In another embodiment, at least one or more of the sound output device 114, the sensor module 119, a light-emitting device (e.g., a flash), and the camera 112 may be provided below the screen display area of the display 101.

According to an embodiment, the display 101 may be combined with or disposed adjacent to a touch detection circuit, a pressure sensor capable of measuring the strength (pressure) of touch, and/or a digitizer that detects a magnetic field-type stylus pen.

According to an embodiment, the input device 103 may include a microphone 103. In a certain embodiment, the input device 103 may include a plurality of microphones 103 arranged to detect the direction of sound. The sound output devices 107 and 114 may include speakers 107 and 114. The speakers 107 and 114 may include an external speaker 107 and a receiver 114 for calls. In a certain embodiment, the microphone 103, the speakers 107 and 114, and the connectors 108 and 109 may be disposed in the space of the electronic device 100 and may be exposed to the external environment through at least one hole formed on the housing 110. In a certain embodiment, the hole formed on the housing 110 may be commonly used for the microphone 103 and the speakers 107 and 114. In a certain embodiment, the sound output devices 107 and 114 may include a speaker (e.g., a piezo speaker) that operates without the hole formed on the housing 110.

According to an embodiment, the sensor modules 104 and 119 may generate electrical signals or data values corresponding to the internal operating state of the electronic device 100 or the external environmental state. The sensor modules 104 and 119 may include, for example, a first sensor module 104 (e.g., a proximity sensor) and/or a second sensor module (not shown) (e.g., a fingerprint sensor) disposed on the first surface 110A of the housing 110, and/or a third sensor module 119 (e.g., an HRM sensor) disposed on the second surface 110B of the housing 110. The fingerprint sensor may be disposed on a portion of the first surface 110A or the second surface 110B of the housing 110, or under the display 101. The electronic device 100 may include sensor modules not shown, for example, at least one of a gesture sensor, a gyro sensor, an atmosphere pressure sensor, a magnetic sensor, an acceleration sensor, a grip sensor, a color sensor, an infrared (IR) sensor, a biometric sensor, a temperature sensor, a humidity sensor, or an illuminance sensor. According to various embodiments, the electronic device 100 may have a bar-type or plate-type appearance, but the disclosure is not limited thereto. For example, the illustrated electronic device 100 may include various types of electronic devices such as a foldable electronic device, a slidable electronic device, a stretchable electronic device, and/or a rollable electronic device.

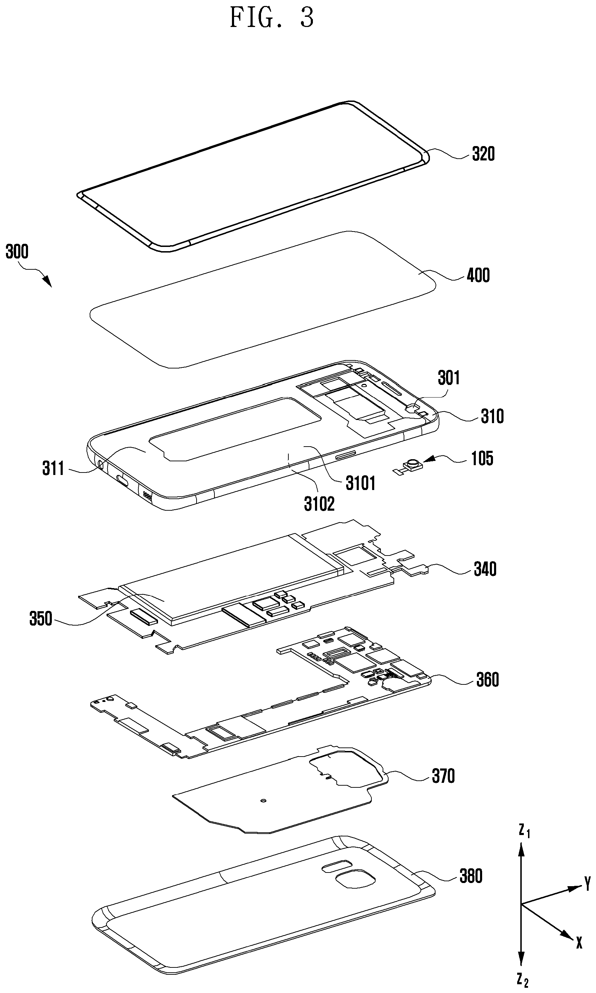

FIG. 3 is an exploded perspective view of the electronic device 100 in FIG. 1 according to various embodiments of the disclosure.

The electronic device 300 in FIG. 3 may be at least partially similar to the electronic device 100 in FIGS. 1 and 2 or may further include other embodiments of the electronic device.

Referring to FIG. 3, the electronic device 300 (e.g., the electronic device 100 in FIG. 1 or FIG. 2) may include a side member 310 (e.g., the side bezel structure 118 in FIG. 2), a first support member 311 (e.g., a bracket or a support structure), a front plate 320 (e.g., a front cover or the front plate 102 in FIG. 1), a display 400 (e.g., the display 101 in FIG. 1), a printed circuit board (PCB) 340 (e.g., a flexible PCB (FPCB) or a rigid flexible PCB (RFPCB)), a battery 350, and a second support member 360 (e.g., a rear case), an antenna 370, and a rear plate 380 (e.g., a rear cover or the rear plate 111 in FIG. 2). In a certain embodiment, the electronic device 300 may exclude at least one (e.g., the first support member 311 or the second support member 360) of the elements or may further include other elements. At least one of the elements of the electronic device 300 may be the same as or similar to at least one of the elements of the electronic device 100 in FIG. 1 or FIG. 2, and redundant descriptions thereof will be omitted below.

According to an embodiment, the first support member 311 may be disposed inside the electronic device 300 to be connected to the side member 310 or may be formed integrally with the side member 310. The first support member 311 may be formed of, for example, a metal material and/or a non-metal material (e.g., polymer). The first support member 311 may have a display 400 coupled to one side thereof and a printed circuit board 340 coupled to the other side.

According to an embodiment, the printed circuit board 340 may be equipped with a processor, a memory, and/or an interface. The processor may include one or more of, for example, a central processing unit, an application processor, a graphics processing unit, an image signal processor, a sensor hub processor, or a communication processor.

According to an embodiment, the memory may include, for example, volatile memory or non-volatile memory.

According to an embodiment, the interface may include, for example, a high-definition multimedia interface (HDMI), a universal serial bus (USB) interface, an SD card interface, and/or an audio interface. For example, the interface may electrically or physically connect the electronic device 300 to an external electronic device and may include a USB connector, an SD card/MMC connector, or an audio connector.

According to an embodiment, the battery 350 is a device for supplying power to at least one component of the electronic device 300 and may include, for example, a non-rechargeable primary battery, a rechargeable secondary battery, or a fuel cell. At least a portion of the battery 350 may be disposed, for example, on substantially the same plane as the printed circuit board 340. The battery 350 may be disposed integrally inside the electronic device 300. In another embodiment, the battery 350 may be disposed to be detachable from the electronic device 300.

According to an embodiment, the antenna 370 may be disposed between the rear plate 380 and the battery 350. The antenna 370 may include, for example, a near-field communication (NFC) antenna, a wireless charging antenna, and/or a magnetic secure transmission (MST) antenna. For example, the antenna 370 may perform short-range communication with an external device or may wirelessly transmit and receive power required for charging. In another embodiment, an antenna structure may be formed by a part of the side bezel structure 310 and/or the first support member 311 or a combination thereof.

According to an embodiment, the second support member 360 (e.g., the rear case) may be disposed between the printed circuit board 340 and the antenna 370. According to an embodiment, the second support member 360 may include one side to which at least one of the printed circuit board 340 or the battery 350 is coupled and the other side to which the antenna 370 is coupled.

According to an embodiment, the first support member 311 of the side member 310 may include a first surface 3101 facing the front plate 320 and a second surface 3102 facing in the opposite direction of the first surface 3101 (e.g., toward the rear plate 380). According to an embodiment, the camera 105 (e.g., the first camera 105 in FIG. 1) may be disposed between the first support member 311 and the rear plate 380. According to an embodiment, the camera 105 may protrude toward the front plate 320 or may be disposed to be visible through a through-hole 301 connected from the first surface 3101 to the second surface 3102 of the first support member 311. According to an embodiment, the protruding portion of the camera 105 through the through-hole 301 may be disposed to detect the external environment at a corresponding position of the display 400. In another embodiment, in the case where the camera 105 is disposed between the display 400 and the first support member 311, the through-hole 301 may be unnecessary.

Hereinafter, the arrangement relationship between the display 400 and the camera 105 in the electronic device 300 will be described in detail.

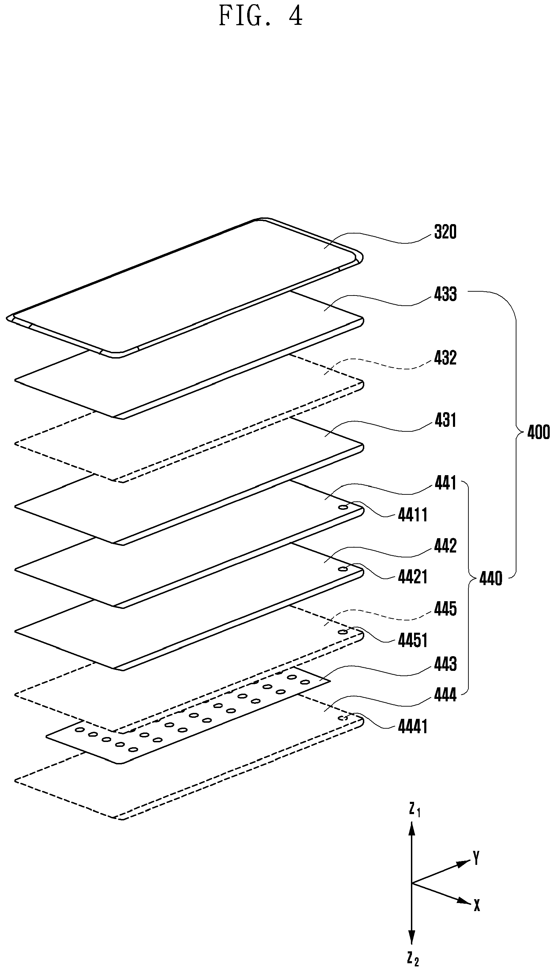

FIG. 4 is an exploded perspective view of a display 400 according to various embodiments shown in FIG. 3.

The display 400 in FIG. 4 may be at least partially similar to the display 101 in FIG. 1 and the display 400 in FIG. 3 or may further include other embodiments of the display.

Referring to FIG. 4, the display 400 according to an embodiment may include a display panel 431, a color filter layer 433 formed in a first direction (e.g., in the z1 direction) from the display panel 431, a touch panel 432 formed between the color filter layer 433 and the display panel 431, and/or a subsidiary material layer 440 formed in a second direction (e.g., in the z2 direction) from the display panel 431. In another embodiment, the touch panel 432 may be formed in the first direction from the color filter layer 433.

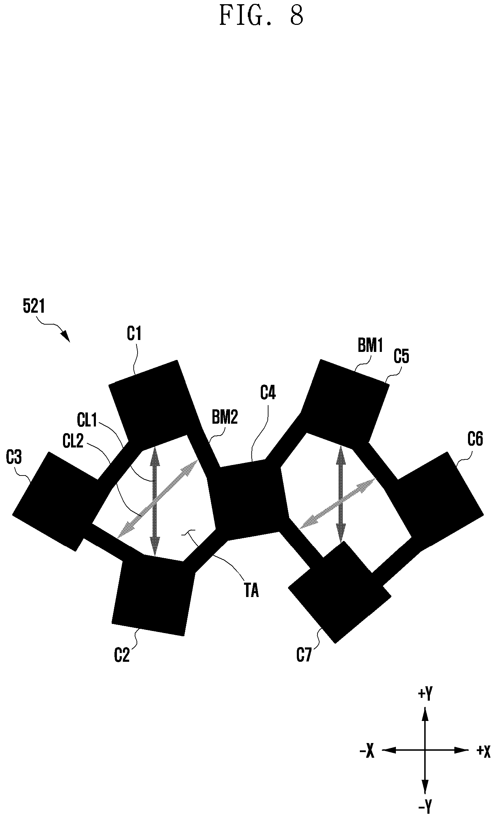

According to an embodiment, the display panel 431 may include organic light-emitting diodes (OLEDs). For example, it may include an unbreakable (UB)-type OLED display (e.g., a curved display). According to an embodiment, the display panel 431 may include a first pixel (e.g., the first pixel R1 in FIG. 8) that displays a first color (e.g., red), a second pixel (e.g., the second pixels G1 in FIG. 8) that displays a second color (e.g., green), and/or a third pixel (e.g., the third pixel B1 in FIG. 8) that displays a third color (e.g., blue). According to an embodiment, the first to third pixels may be disposed side by side according to a designated rule. For example, the first to third pixels may be disposed side by side with each other on the xy plane shown in FIG. 4. According to various embodiments, the display panel 431 may include pixels of more colors, in addition to the pixels of three colors. For example, the display panel 431 may include pixels of three or more colors. According to various embodiments, the method in which pixels of the display panel 431 are arranged may be modified or changed in various ways. According to various embodiments, the areas or shapes of the pixels of the display panel 431 may be modified or changed in various ways.

According to an embodiment, the display 400 may include a color filter layer 433 of a color filter-on-encapsulation (COE) type, instead of a polarizer (POL) (e.g., a circular polarizer (retarder)). According to an embodiment, the display 400 may increase transmittance and reduce thickness by excluding the polarizer (POL). For example, the display 400 excluding the POL according to an embodiment may exhibit improvement in the transmittance by 20% or more and a reduction in the thickness by about 100 um to about 150 um, compared to an existing display including the POL. According to an embodiment, the color filter layer 433 may perform the same or similar function as the POL applied to a display including organic light-emitting diodes (OLEDs). For example, the color filter layer 433 may block reflected light from the display panel 431, thereby improving the outdoor visibility.

According to an embodiment, the subsidiary material layer 440 may include at least one or more polymer members 441 and 442 disposed on the rear surface (e.g., the surface facing in the second direction (in the z2 direction)) of the display panel 431, at least one functional member 443 disposed on the rear surface (e.g., the surface facing in the second direction (in the z2 direction)) of the one or more polymer members 441 and 442, and a metal sheet 444 disposed on the rear surface (e.g., the surface facing in the second direction (in the z2 direction)) of the at least one functional member 443.

According to an embodiment, the at least one or more polymer members 441 and 442 may include a light-blocking layer 441 (e.g., a black layer including an uneven pattern) for removing air bubbles that may be generated between the display panel 431 and lower attachments thereto (e.g., in the second direction (the z2 direction)) and blocking light produced from the display panel 431 or light incident from the outside, and/or a buffer layer 442 (e.g., a sponge layer) disposed to relieve impacts. According to an embodiment, the buffer layer 442 may include a buffer member (cushion) made of polymer.

According to an embodiment, at least one functional member 443 may include a heat dissipation sheet (e.g., a graphite sheet) for heat dissipation, a force touch FPCB, a fingerprint sensor FPCB, a communication antenna radiator, a conductive/non-conductive tape, or an open cell sponge.

According to an embodiment, the metal sheet 444 is a conductive member (e.g., a metal plate) that may help reinforce the rigidity of an electronic device (e.g., the electronic device 300 in FIG. 3) and may be used to shield ambient noise and disperse heat emitted from surrounding heat-emitting components. According to an embodiment, the metal sheet 444 may include at least one of Cu, Al, Mg, steel-use stainless (SUS) (e.g., stainless steel (STS)), or CLAD (e.g., a laminated member in which SUS and Al are alternately provided). In a certain embodiment, the metal sheet 444 may include other alloy materials.

According to an embodiment, the subsidiary material layer 440 of the display 400 may further include a detection member 445 for detecting an input by an electromagnetic induction-type writing tool (e.g., an electronic pen). According to an embodiment, the detection member 445 is a digitizer and may include a coil member disposed on a dielectric substrate to detect an electromagnetic induction resonance frequency applied from an electronic pen. In a certain embodiment, detection member 445 may be omitted. According to an embodiment, the detection member 445 may be disposed between at least one or more polymer members 441 and 442 and the functional member 443. In another embodiment, the detection member 445 may be disposed between the display panel 431 and at least one or more polymer members 441 and 442. In another embodiment, the detection member 445 may be disposed under the metal sheet 444.

According to various embodiments, the subsidiary material layer 440 may include openings 4411, 4421, 4451, and 4441 formed at positions overlapping a camera (e.g., the camera 105 in FIG. 3). According to an embodiment, the openings 4411, 4421, 4451, and 4441 may be formed by removing portions of the subsidiary material layer 440 overlapping the camera 105. According to an embodiment, the camera 105 may be disposed close to the rear surface (e.g., the surface facing in the second direction (the z2 direction)) of the display panel 431 through the openings 4411, 4421, 4451, and 4441. According to an embodiment, the sizes (e.g., diameters or areas) of the plurality of openings 4411, 4421, 4451, and 4441 may be configured based on the size of the camera 105 and/or the angle of view of the camera 105, and the openings 4411, 4421, 4451, and 4441 may have different sizes from each other.

According to an embodiment, a front cover 320 (e.g., a front plate, a glass plate, a first cover member, or a cover member) may be provided in the first direction from the display 400. According to an embodiment, the front cover 320 may include a glass layer. For example, the front cover 320 may include ultra-thin glass (UTG). In a certain embodiment, the front cover 320 may include polymer. For example, the front cover 320 may include polyethylene terephthalate (PET) or polyimide (PI). In a certain embodiment, a plurality of front covers 320 may be disposed. In a certain embodiment, one layer of the plurality of front covers 320 may be disposed using an adhesive having adhesion less than that of other layers or an adhesive thinner than those of other layers such that it may be easily separated from other layers. According to an embodiment, the adhesive may include an optical clear adhesive (OCA), a pressure sensitive adhesive (PSA), a heat-reactive adhesive, a light-reactive adhesive, a general adhesive, and/or a double-sided tape.

According to an embodiment, the display 400 may exclude at least one of the touch panel 432, the detection member 445, and/or the metal sheet 444.

According to an embodiment, the display 400 may include a control module (not shown). According to an embodiment, the control module may include an FPCB that electrically connects a printed circuit board (e.g., the printed circuit board 340 in FIG. 3) of an electronic device (e.g., the electronic device 300 in FIG. 3) with the display panel 431, and a display driver IC (DID) mounted on the FPCB. According to an embodiment, the control module (not shown) may include a display driver IC (DDI) and/or a touch display driver IC (TDDI) disposed in a chip-on-panel (COF) or chip-on-film (COF) manner.

In an embodiment, the display 400 may include a fingerprint sensor (not shown) disposed around the control module. According to an embodiment, the fingerprint sensor may include an ultrasonic or optical fingerprint sensor capable of recognizing the fingerprint of a finger that comes into contact therewith or approaches from the outer surface of the front cover 320 through a hole at least partially formed in some of the elements of the display 400.

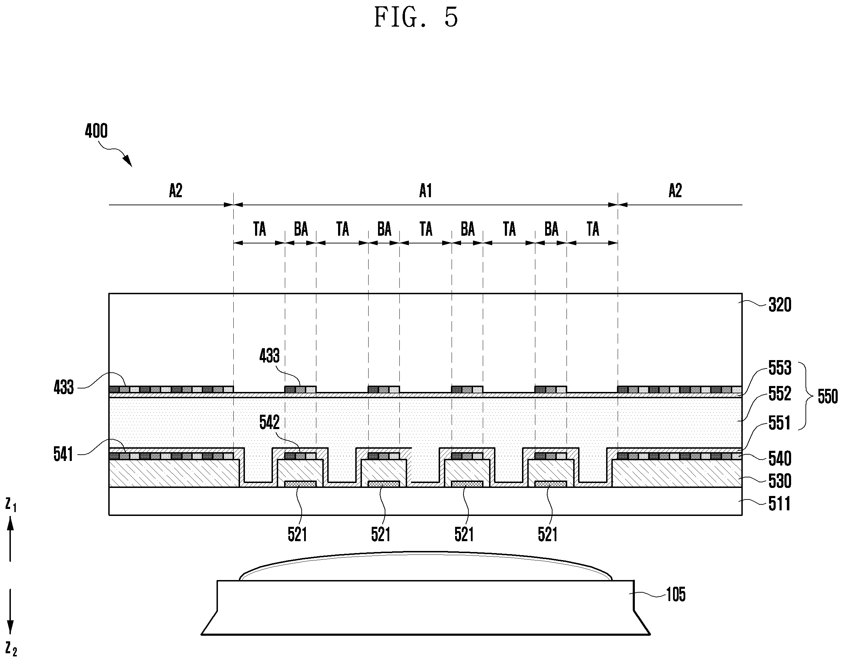

FIG. 5 is a cross-sectional view illustrating an overlap area (e.g., a first area A1) of a camera 105 of a display 400 according to an embodiment. For example, FIG. 5 may be a partially cross-sectional view of the electronic device 100 viewed from 'line 5-5' in FIG. 1.

The display 400 shown in FIG. 5 may be at least partially similar to the display 400 shown in FIG. 4 or may further include different embodiments.

Referring to FIG. 5, the display 400 according to an embodiment may include a substrate 511, a black mask 521 formed in a first direction z1 (e.g., the upward direction) from the substrate 511, and a silicon layer (e.g., a low-temperature polycrystalline silicon (LTPS) or a low-temperature polycrystalline oxide (LTPO)) 530 formed in the first direction z1 from the substrate 511 including the black mask 521, a pixel layer 540 formed in the first direction z1 from the silicon layer 530, and/or an organic encapsulation layer 550 formed in the first direction z1 from the pixel layer 540. According to an embodiment, a color filter layer 433 may be formed in the first direction z1 from the organic encapsulation layer 550 of the display 400. According to an embodiment, a touch sensor layer (e.g., the touch panel 432 in FIG. 4), which is not shown, may be further formed between the organic encapsulation layer 550 and the color filter layer 433. According to another embodiment, the touch sensor layer may be formed in the first direction z1 from the color filter layer 433. A window may be disposed as a front cover (e.g., the front cover 320 in FIG. 4) in the first direction z1 of the display 400.

According to an embodiment, the silicon layer 530 may include a thin film transistor (TFT) (not shown) and a plurality of wires for driving the pixel layer 540.

According to an embodiment, pixels and a plurality of transparent wires electrically connected to the pixels may be disposed, instead of a driving circuit for driving the pixels, in the first area A1. According to an embodiment, in the case where a driving circuit for driving pixels is not disposed in the first area A1, the pixels disposed in the first area A1 may be driven by a driving circuit disposed in the second area A2. According to an embodiment, in the case where a driving circuit for driving pixels is not disposed in the first area A1, the pixels disposed in the first area A1 may be driven by a driving circuit (not shown) disposed between the first area A1 and the second area A2. According to an embodiment, in the case where a driving circuit for driving pixels is not disposed in the first area A1, the pixels disposed in the first area A1 may be driven by a driving circuit (not shown) disposed in the second area A2 to drive the pixels disposed in the second area A2. In this case, one driving circuit (not shown) disposed in the second area A2 may drive the pixels disposed in the first area A1, as well as the pixels disposed in the second area A2. For example, in the case where a red pixel is disposed in a second area A2 and where a driving circuit for driving the red pixel of the second area A2 is disposed in the second area A2, the driving circuit may drive the red pixel in the first area A1, as well as the red pixel in the second area A2.

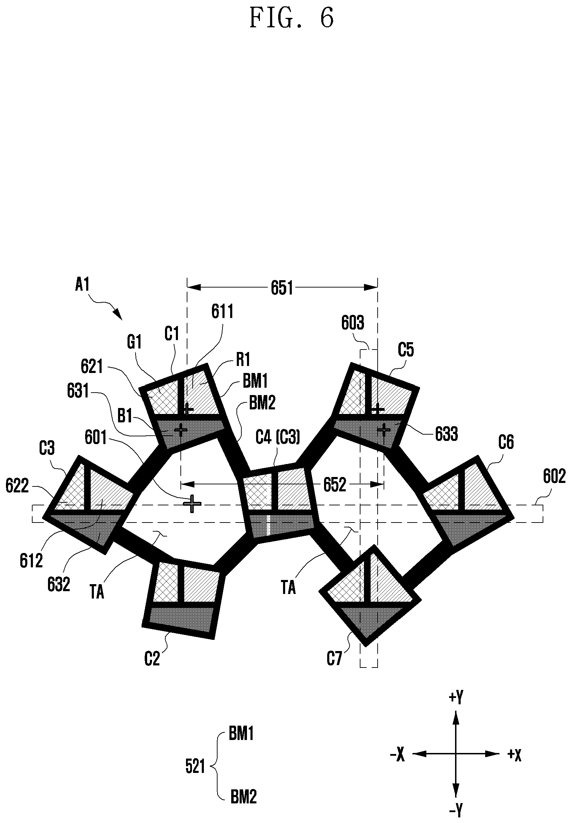

According to an embodiment, the pixel layer 540 may include pixels of organic light-emitting diodes (OLEDs). According to an embodiment, the pixel layer 540 may include a first sub-pixel (e.g., the first sub-pixel R1 in FIG. 6) that displays a first color (e.g., red), a second sub-pixel (e.g., the second sub-pixel G1 in FIG. 6) that displays a second color (e.g., green), and/or a third sub-pixel (e.g., the third sub-pixel B1 in FIG. 6) that displays a third color (e.g., blue). According to an embodiment, the first to third sub-pixels formed in the second area A2 may be arranged according to a designated rule. According to an embodiment, the first to third sub-pixels formed in the first area A1 may be arranged irregularly in order to prevent unintentional diffraction of light. According to an embodiment, in order to prevent unintentional diffraction of light, the driving circuits or wires formed in the first area A1 may be arranged irregularly.

According to an embodiment, in the first area A1, a first group of pixels 542 may be arranged, and a black mask 521 and a color filter layer 433 may be arranged to overlap the first group of pixels 542. According to an embodiment, an area that at least partially overlaps the first group of pixels 542 may be referred to as a light-blocking area BA.

According to an embodiment, the black mask 521 may be an opaque metal. According to various embodiments, the black mask 521 may be changed or modified to terms such as an anti-light diffraction film, an anti-light transmission film, a low-reflection anti-light diffraction film, or a low-reflection anti-light transmission film. According to various embodiments, the material of the black mask 521 may be configured as organic or inorganic materials in addition to the opaque metal. According to an embodiment, the material of the black mask 521 may include a complex stacked structure of metal, organic layers, and inorganic layers. According to an embodiment, unlike the illustrated example, the black mask 521 may be disposed inside the substrate 511, under the substrate 511, or on least some layers between the pixel and the substrate 511.

According to an embodiment, the black mask 521 may not be formed in the area between the first group of pixels 542. For example, the area between the first group of pixels 542 may be named a transmission area TA.

According to an embodiment, a second group of pixels 541 may be disposed in the second area A2, and a color filter layer 433 may be disposed to overlap the second group of pixels 541.

According to an embodiment, the density at which the first group of pixels 542 are disposed may be lower than the density at which the second group of pixels 541 are disposed. For example, the second group of pixels 541 may be disposed more densely than the first group of pixels 542. According to an embodiment, the first group of pixels 542 may be designed to have a lower arrangement density than the second group of pixels 541, thereby increasing the transmittance of the first area A1.

According to an embodiment, the organic encapsulation layer 550 may include a first inorganic layer 551 formed in the first direction z1 from the pixel layer 540, an organic layer 552 formed in the first direction z1 from the first inorganic layer 551, and a second inorganic layer 553 formed in the first direction z1 from the organic layer 552.

According to an embodiment, the pixel layer 540 and the silicon layer 530 may be removed from the transmission area TA. For example, the substrate 511 and the organic encapsulation layer 550 may come into contact with each other in the transmission area TA. For example, the substrate 511 and the first inorganic layer 551 of the organic encapsulation layer 550 may come into contact with each other in the transmission area TA.

According to an embodiment, the pixel layer 540 may include pixels of organic light-emitting diodes (OLEDs). According to an embodiment, the pixel layer 540 may include a first sub-pixel (e.g., the first sub-pixel R1 in FIG. 6) that displays a first color (e.g., red), a second sub-pixel (e.g., the second sub-pixel G1 in FIG. 6) that displays a second color (e.g., green), and/or a third sub-pixel (e.g., the third sub-pixel B1 in FIG. 6) that displays a third color (e.g., blue). According to an embodiment, the first to third sub-pixels formed in the second area A2 may be arranged according to a designated rule. According to an embodiment, the first to third sub-pixels formed in the first area A1 may be arranged irregularly in order to prevent unintentional diffraction of light.

According to an embodiment, the size of the pixel disposed in the first area A1 may be different from the size of the pixel disposed in the second area A2. According to an embodiment, the size of the pixel disposed in the first area A1 may be smaller than the size of the pixel disposed in the second area A2, and accordingly, the transmittance of the first area A1 may be designed to be greater than the transmittance of the second area A2. According to an embodiment, one pixel disposed in the first area A1 may be driven such that the brightness of light emitted therefrom is greater than the brightness of light emitted from one pixel disposed in the second area A2, thereby reducing the difference in brightness between the first area A1 and the second area A2. In this case, the electronic device 300 may be designed such that the size of the pixel disposed in the first area A1 is greater than the size of the pixels disposed in the second area A2 in order to reduce the burn-in difference between the first area A1 and the second area A2.

FIG. 6 is a diagram illustrating an example of an enlarged camera overlap area (e.g., the first area A1) of a display 400 according to an embodiment.

Referring to FIG. 6, in the first area A1 of the display 400 according to an embodiment, a first group of pixels 542 overlapping at least a portion of a camera (e.g., the camera 105 in FIG. 5) may be arranged irregularly.

According to an embodiment, the first group of pixels 542 may include a first sub-pixel R1 that displays a first color (e.g., red), a second sub-pixel G1 that displays a second color (e.g., green), and/or a third sub-pixel B1 that displays a third color (e.g., blue).

According to an embodiment, one first sub-pixel R1, one second sub-pixel G1, and one third sub-pixel B1 may be disposed adjacent to each other to form one cluster (or one unit pixel). For example, a plurality of clusters C1, C2, C3, C4, C5, C6, and C7 may be arranged in the first area A1 of the display 400, and each of the plurality of clusters C1, C2, C3, C4, C5, C6, and C7 may include a first sub-pixel R1 displaying a first color (e.g., red), a second sub-pixel G1 displaying a second color (e.g., green), and/or a third sub-pixel B1 displaying a third color (e.g., blue), which are disposed adjacent to each other.

According to an embodiment, in the first area A1, a transmission area TA may be formed the area in which the first group of pixels 542 are not formed, for example, between the plurality of clusters C1, C2, C3, C4, C5, C6, and C7.

According to an embodiment, the plurality of clusters C1, C2, C3, C4, C5, C6, and C7 may be arranged in a matrix form in the first area A1. For example, the plurality of clusters C1, C2, C3, C4, C5, C6, and C7 may be arranged to form a plurality of rows and a plurality of columns. According to an embodiment, among the plurality of clusters C1, C2, C3, C4, C5, C6, and C7, the clusters C1, C2, C5, and C7 in odd-numbered rows (e.g., the n^{th} row, or the n+2^{th} row) and the clusters C3, C4, and C6 in even-numbered rows (e.g., the n+1^{th} row) may be disposed in a staggered arrangement. For example, the first cluster C1 and the fifth cluster C5 may be disposed side by side in the n^{th} row, and the second cluster C2 and the seventh cluster C7 may be disposed side by side in the n+2^{th} row. For example, the third cluster C3, the fourth cluster C4, and the sixth cluster C6 may be disposed side by side in the n+1^{th} row. The clusters C3, C4, and C6 in the n+1^{th} row and the clusters C1, C5, C2, and C7 in the n^{th} row or n+2^{th} row may be disposed to be staggered with each other.

According to an embodiment, the plurality of clusters C1, C2, C3, C4, C5, C6, and C7 may include four clusters (e.g., C1, C2, C3, and C4) disposed in the +X direction, the -X direction, the +Y direction, and the -Y direction with respect to the center 601 of a specific transmission area TA. The +X direction and the -X direction may be opposite directions to each other. The +Y direction and the -Y direction may be opposite directions to each other and may be perpendicular to the +X direction and the -X direction.

According to an embodiment, based on the center 601 of an arbitrary transmission area TA, the cluster disposed in the +Y direction from the center 601 may be referred to as a first cluster C1.

According to an embodiment, based on the center 601 of an arbitrary transmission area TA, the cluster disposed in the -Y direction from the center 601 may be referred to as a second cluster C2.

According to an embodiment, based on the center 601 of an arbitrary transmission area TA, the cluster disposed in the -X direction from the center 601 may be referred to as a third cluster C3.

According to an embodiment, based on the center 601 of an arbitrary transmission area TA, the cluster disposed in the +X direction from the center 601 may be referred to as a fourth cluster C4.

According to an embodiment, each of the first to fourth clusters C1, C2, C3, and C4 may include the first group of pixels 542, that is, a first sub-pixel R1 displaying a first color (e.g., red), a second sub-pixel G1 displaying a second color (e.g., green), and/or a third sub-pixel B1 displaying a third color (e.g., blue).

According to an embodiment, the first to fourth clusters C1, C2, C3, and C4 may be electrically connected to each other by at least one or more wires (not shown). The wires may include signal wires (not shown) for driving the first group of pixels 542 or wires (not shown) associated with a touch panel. These wires (not shown) may be formed to overlap a portion of the black mask 521.

According to an embodiment, the first to fourth clusters C1, C2, C3, and C4 may be formed in different directions from each other to reduce light diffraction. For example, when the first area A1 of the display 400 is viewed on the XY plane, the boundary lines of the first to fourth clusters C1, C2, C3, and C4 may be formed in different directions from each other.

According to an embodiment, sub-pixels of the same color disposed in different clusters may have different arrangement angles and shapes, and may have the same light-emitting area. For example, the angle and shape of the first sub-pixel R1 included in the first cluster C1 may be different from the angle and shape of the first sub-pixel R1 included in the third cluster C3. The light-emitting area of the first sub-pixel R1 included in the first cluster C1 may be the same as the light-emitting area of the first sub-pixel R1 included in the third cluster C3.

In FIG. 6, '611' may represent the area of the first sub-pixel R1 included in the first cluster C1, and '612' may represent the area of the first sub-pixel R1 included in the third cluster C1. Comparing the area according to 611 with the area according to 612, the angles and shapes of the areas may be different, and the areas thereof may be the same.

In FIG. 6, '621' may represent the area of the second sub-pixel G1 included in the first cluster C1, and '622' may represent the area of the second sub-pixel G1 included in the third cluster C1. Comparing the area according to 621 with the area according to 622, the angles and shapes of the areas may be different, and the areas thereof may be the same.

In FIG. 6, '631' may represent the area of the third sub-pixel B1 included in the first cluster C1, and '632' may represent the area of the third sub-pixel B1 included in the third cluster C3. '633' may represent the area of the third sub-pixel B1 included in the fifth cluster C5. Comparing the area according to 631, the area according to 632, and the area according to 633, the angles and shapes may be different, and the areas may be the same.

According to an embodiment, each of the plurality of clusters C1, C2, C3, C4, C5, C6, and C7 may include boundary lines that partition the first sub-pixel R1, the second sub-pixel G1, and the third sub-pixel B1, and the boundary line may be formed by a pixel definition layer (PDL) (not shown). According to an embodiment, the boundary lines formed inside the clusters disposed in the same row among the plurality of clusters C1, C2, C3, C4, C5, C6, and C7 may be disposed on a virtual horizontal straight line (e.g., 602 in FIG. 6). For example, the third cluster C3, the fourth cluster C4, and the sixth cluster C6 may be disposed in the same row, and some boundary lines formed inside the respective clusters may be formed to correspond to a virtual horizontal straight line (e.g., 602 in FIG. 6). According to an embodiment, the boundary lines formed inside the clusters disposed in the same column among the plurality of clusters C1, C2, C3, C4, C5, C6, and C7 may be disposed on a virtual vertical straight line (e.g., 603 in FIG. 6). For example, the fifth cluster C3 and the seventh cluster C7 may be disposed in the same column, and some boundary lines formed inside the respective clusters may be formed to correspond to a virtual vertical straight line (e.g., 603 in FIG. 6).

According to an embodiment, the centers of the respective clusters C1, C2, C3, C4, C5, C6, and C7 may be arranged at regular intervals. For example, in FIG. 6, '651' may represent the distance between the centers of the first cluster C1 and the fifth cluster C5 disposed in the same row, and the distance between the centers may remain constant in the clusters disposed in the same row as the first cluster C1 and the fifth cluster C5.

According to an embodiment, the distance between the centers of sub-pixels of the same color disposed in different clusters may be irregular, instead of being constant. For example, in FIG. 6, '652' may indicate the distance between the center of the third sub-pixel B1 in the first cluster C1 and the center of the third sub-pixel B1 in the fifth cluster C5, which are disposed in the same row, and the distance between centers may be irregular, instead of being constant, in the clusters disposed in the same row as the first cluster C1 and the fifth cluster C5.

According to an embodiment, a black mask (e.g., the black mask 521 in FIG. 5) may be disposed to overlap each of the first to fourth clusters C1, C2, C3, and C4 in the first area A1. According to an embodiment, the black mask 521 may include a first black mask BM1 formed to overlap each of the first to fourth cluster C1, C2, C3, and C4 and a second black mask BM2 formed to overlap at least one wire connecting the first to fourth clusters C1, C2, C3, and C4 to each other. According to an embodiment, the black mask 521 is intended to reduce unintentional diffraction of light in the first area A1, and a transmission area TA having a designated pattern may be formed by controlling the shape, size, and/or arrangement density.

According to an embodiment, the angles of the second black masks BM2 formed to overlap at least one wire connecting the first to fourth clusters C1, C2, C3, and C4 to each other may be different from each other and may be formed irregularly. According to an embodiment, the angles of the second black masks BM2 extending from the respective clusters disposed in the same row may be irregular, instead of being constant. For example, the angle of the second black mask BM2 adjacent to the third sub-pixel B1 of the first cluster C1 and the angle of the second black mask BM2 adjacent to the third sub-pixel B1 of the fifth cluster C5 may be different from each other.

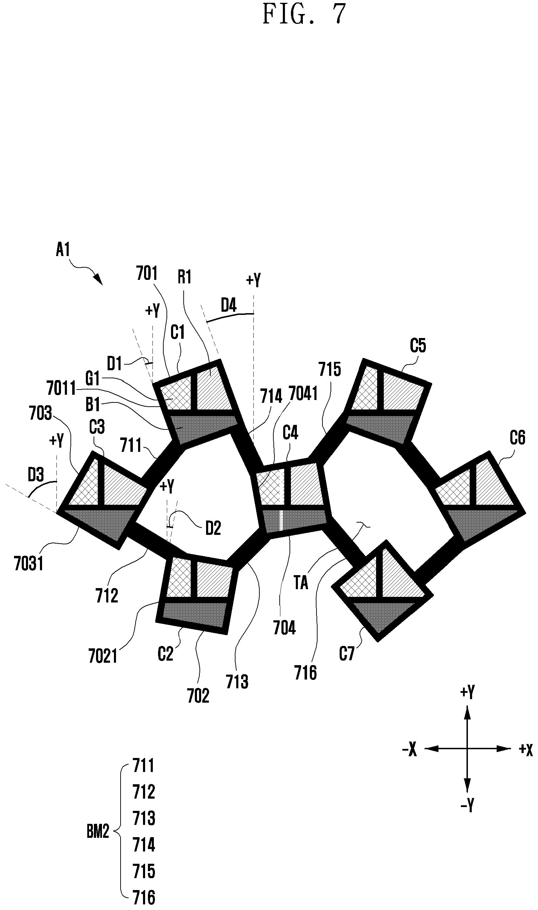

FIG. 7 is a diagram illustrating an example of the irregular arrangement of clusters according to an embodiment.

Referring to FIG. 7, in the first area A1 of the display 400 according to an embodiment, a plurality of clusters C1, C2, C3, C4, C5, C6, and C7 may be arranged, and the first to fourth clusters C1, C2, C3, and C4 among the plurality of clusters C1, C2, C3, C4, C5, C6, and C7 may be disposed adjacent to each other, based on one of a plurality of transmission areas TA formed in the first area A1. Hereinafter, a description will be made based on the first to fourth clusters C1, C2, C3, and C4 disposed adjacent to each other, based on a specific transmission area TA.

The clusters C1, C2, C3, and C4 according to an embodiment may be arranged in different directions from each other when the display 400 is viewed from above, for example, on the XY plane. For example, the boundary lines 701, 702, 703, and 704 of the respective clusters C1, C2, C3, and C4 may have a rectangular shape and may be tilted at predetermined angles relative to a virtual reference axis (e.g., the +Y axis) passing through the display in the vertical direction. The angles at which the boundary lines 701, 702, 703, and 704 of the respective clusters C1, C2, C3, and C4 are tilted relative to the virtual reference axis (e.g., the +Y axis) may be irregular. For example, the angles at which the boundary lines 701, 702, 703, and 704 of the respective clusters C1, C2, C3, and C4 are tilted relative to the virtual reference axis (e.g., the +Y axis) may be different from each other.

According to an embodiment, the directions of some boundary lines 7011, 7021, 7031, and 7041 adjacent to specific sub-pixels of the same color in the respective clusters C1, C2, C3, and C4 may be different from each other.

According to an embodiment, the outer boundary line (e.g., the first boundary line 701) of the first cluster C1 may have a rectangular shape and may be tilted at a first angle D1 with respect to the reference axis (e.g., the +Y axis). For example, a partial boundary line (e.g., the boundary line 7011) of the outer boundary line 701 of the first cluster C1, which is adjacent to a designated sub-pixel (hereinafter, exemplified as the second sub-pixel G1) displaying a specific color, may be formed in the first direction while being tilted at a first angle D1 with respect to the reference axis (e.g., the +Y axis). For example, the first cluster C1 may be disposed such that the partial outer boundary line (e.g., the boundary line 7011) adjacent to the second sub-pixel G1 of the first cluster C1 and the +Y axis form a first angle D1.

According to an embodiment, the outer boundary line (e.g., the second boundary line 702) of the second cluster C2 may have a rectangular shape and may be tilted at a second angle D2 with respect to the reference axis (e.g., the +Y axis). For example, a partial boundary line (e.g., the boundary line 7021) of the outer boundary line 702 of the second cluster C2, which is adjacent to a designated sub-pixel (hereinafter, exemplified as the second sub-pixel G1) displaying a specific color, may be formed in the second direction while being tilted at a second angle D2 with respect to the reference axis (e.g., the +Y axis). For example, the second cluster C2 may be disposed such that the partial outer boundary line (e.g., the boundary line 7021) adjacent to the second sub-pixel G1 of the second cluster C2 and the +Y axis form a second angle D2. The second angle D2 may be different from the first angle D1.

According to an embodiment, the outer boundary line (e.g., the third boundary line 703) of the third cluster C3 may have a rectangular shape and may be tilted at a third angle D3 with respect to the reference axis (e.g., the +Y axis). For example, a partial boundary line (e.g., the boundary line 7031) of the outer boundary line 703 of the third cluster C3, which is adjacent to a designated sub-pixel (hereinafter, exemplified as the second sub-pixel G1) displaying a specific color, may be formed in the third direction while being tilted at a third angle D3 with respect to the reference axis (e.g., the +Y axis). For example, the third cluster C3 may be disposed such that the partial outer boundary line (e.g., the boundary line 7031) adjacent to the second sub-pixel G1 of the third cluster C3 and the +Y axis form a third angle D3. The third angle D3 may be different from the first angle D1 and the second angle D2.

According to an embodiment, the outer boundary line (e.g., the fourth boundary line 704) of the fourth cluster C4 may have a rectangular shape and may be tilted at a fourth angle D4 with respect to the reference axis (e.g., the +Y axis). For example, a partial boundary line (e.g., the boundary line 7041) of the outer boundary line 704 of the fourth cluster C4, which is adjacent to a designated sub-pixel (hereinafter, exemplified as the second sub-pixel G1) displaying a specific color, may be formed in the fourth direction while being tilted at a fourth angle D4 with respect to the reference axis (e.g., the +Y axis). For example, the fourth cluster C4 may be disposed such that the partial outer boundary line (e.g., the boundary line 7041) adjacent to the second sub-pixel G1 of the fourth cluster C4 and the +Y axis form a fourth angle D4. The fourth angle D4 may be different from the first angle D1, the second angle D2, and the third angle D3.

In the above embodiment, although it is exemplified that the designated sub-pixel displaying a specific color is the second sub-pixel G1, the designated sub-pixel may be the first sub-pixel R1 or the third sub-pixel B1. That is, although the angles at which the boundary lines of the respective clusters C1, C2, C3, and C4 are aligned are compared with each other, based on the partial boundary lines adjacent to the second sub-pixel G1 of each of the clusters C1, C2, C3, and C4, this is only an example, and it will be the same even if the angles of the boundary lines of the clusters C1, C2, C3, and C4 are compared based on the boundary lines adjacent to the sub-pixel of another specific color.

According to various embodiments, as the directions of the boundary lines of the adjacent clusters C1, C2, C3, and C4 are different from each other, it is possible to reduce unintentional diffraction of light and improve the quality of images captured by the UDC (e.g., the camera 105 in FIG. 5).

According to an embodiment, at least one or more wires connecting the first to fourth clusters C1, C2, C3, and C4 may be disposed in the first area A1 of the display 400, and the wires may be disposed to overlap the second black mask BM2. For example, the second black mask BM2 may define an area where at least one wire is formed.

According to an embodiment, the angles of respective wire parts defined by the second black mask BM2 may be different from each other and may be formed irregularly. According to an embodiment, the angles of the wire parts extending from the respective clusters disposed in the same row may be irregular, instead of being constant.

According to an embodiment, the second black mask BM2 may include a first wire part 711, a second wire part 712, a third wire part 713, and a fourth wire part 714.

The first wire part 711 of the second black mask BM2 may be disposed to overlap at least one wire connecting the first cluster C1 and the third cluster C3.

The second wire part 712 of the second black mask BM2 may be disposed to overlap at least one wire connecting the second cluster C2 and the third cluster C3.

The third wire part 713 of the second black mask BM2 may be disposed to overlap at least one wire connecting the second cluster C2 and the fourth cluster C4.

The fourth wire part 714 of the second black mask BM2 may be disposed to overlap at least one wire connecting the first cluster C1 and the fourth cluster C4.

According to an embodiment, based on a virtual reference axis (e.g., the +Y axis), the tilted angle of the first wire part 711, the tilted angle of the second wire part 712, and the tilted angle of the third wire part 713, and the tilted angle of the fourth wire part 714 may be different from each other.

According to an embodiment, based on a virtual reference axis (e.g., the +Y axis), the tilted angles of the first wire parts 711 extending from the clusters in the same row (or a designated row) (e.g., the n+1^{th} row including the third cluster C3 and the fourth cluster C4) may be irregular. For example, based on a virtual reference axis (e.g., the +Y axis), the tilted angle of the first wire part 711 extending from the first cluster C1 may be different from the tilted angle of the fifth wire part 715 extending from the fifth cluster formed in the same row as the first cluster C1. The fifth wire part 715 may correspond to the first wire part 711 when the fifth cluster is defined as the first cluster C1.

According to an embodiment, based on a virtual reference axis (e.g., the +Y axis), the tilted angles of the second wire parts 712 extending from the clusters in the same row (e.g., the n+1^{th} row including the third cluster C3 and the fourth cluster C4) may be irregular. For example, based on a virtual reference axis (e.g., the +Y axis), the tilted angle of the second wire part 712 extending from the third cluster C3 may be different from the tilted angle of the sixth wire part 716 extending from the fourth cluster C4 formed in the same row as the third cluster C3. The sixth wire part 716 may correspond to the second wire part 712 when the fourth cluster C4 is defined as the third cluster C3.

Similar to the above examples, according to an embodiment, based on a virtual reference axis (e.g., the +Y axis), the tilted angles of the third wire parts 713 extending from the clusters in the same row (e.g., the n+1^{th} row including the third cluster C3 and the fourth cluster C4) may be irregular. Alternatively, based on a virtual reference axis (e.g., the +Y axis), the tilted angles of the fourth wire parts 714 extending from the clusters in the same row (e.g., the n+1^{th} row including the third cluster C3 and the fourth cluster C4) may be irregular.

According to various embodiments, since the angles of the respective wire parts defined by the second black mask BM2 are different from each other and are formed irregularly, it is possible to reduce unintentional diffraction of light and improve the quality of images captured by the UDC (e.g., the camera 105 in FIG. 5).

FIG. 8 is a diagram illustrating an example of a black mask according to an embodiment.

Referring to FIG. 8, a black mask 521 according to an embodiment may include a first black mask BM1 formed to overlap each of the first to fourth cluster C1, C2, C3, and C4 and a second black mask BM2 formed to overlap wires connecting the first to fourth clusters C1, C2, C3, and C4 to each other.

According to an embodiment, since the directions of the first to fourth clusters C1, C2, C3, and C4 are different from each other, and since the lengths of the wires for connecting them are also different from each other, the shape and form of the transmission area TA may be modified in various ways in the first area A1. For example, a plurality of transmission areas TA where the black mask 521 is not formed may be formed in the first area A1, and the shapes and forms of the respective transmission areas TA may be different from each other.

According to an embodiment, in any transmission area TA, the gap between clusters (e.g., the first cluster C1 and the second cluster C2) (e.g., the gap between the first black masks BM1) may have a first distance CL1, and the gap between wires disposed diagonally (e.g., the gap between the second black masks BM2) may have a second distance CL2, which is different from the first distance CL1. For example, the gap between the wire (e.g., the fourth wire part 714 in FIG. 7) connecting the first cluster C1 and the fourth cluster C4 to each other and the wire (e.g., the second wire part 712 in FIG. 7) connecting the second cluster C2 and the third cluster C3 to each other may have a second distance CL2.

According to various embodiments, as the shapes and forms of the respective transmission areas TA are formed differently from each other, it is possible to reduce unintentional diffraction of light and improve the quality of images captured by the UDC (e.g., the camera 105 in FIG. 5).

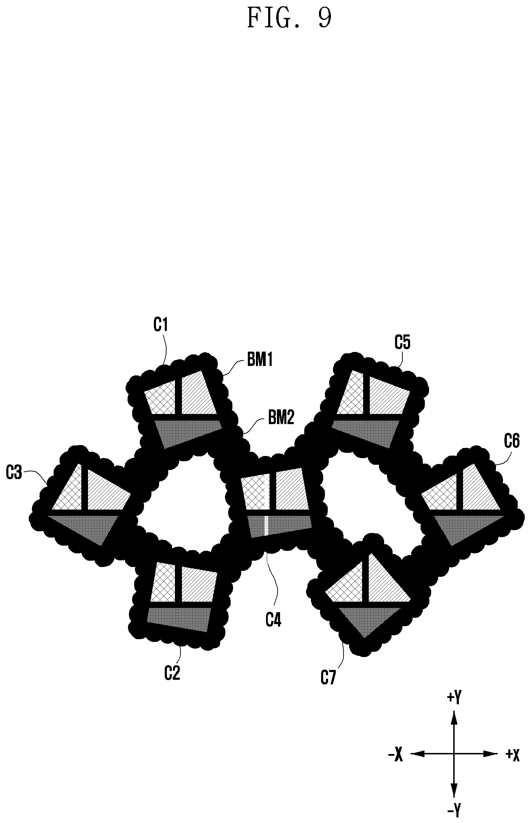

FIG. 9 is a diagram illustrating an example of the form of a black mask according to an embodiment.

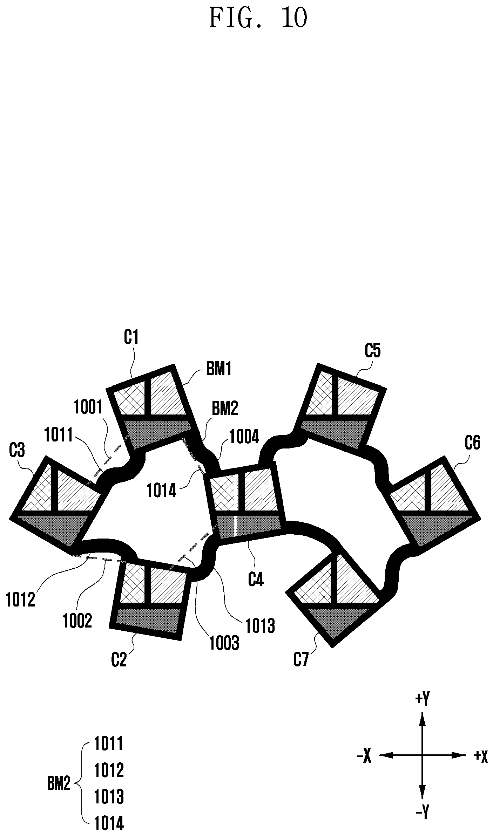

FIG. 10 is a diagram illustrating an example of the form of a black mask according to another embodiment.

Referring to FIGS. 9 and 10, the boundary lines of the black mask 521 according to an embodiment may be designed in various shapes.

Referring to FIG. 9, the boundary lines of each of the first black masks BM1 and the second black masks BM2 may have a wave shape with a designated curvature. According to an embodiment, although not shown, the boundary lines of the first black masks BM1 may have a wave shape with a first curvature, and the boundary lines of the second black masks BM2 may have a wave shape with a second curvature, which is different from the first curvature. In a certain embodiment, the first curvature and the second curvature may be the same.

Referring to FIG. 10, the second black mask BM2 may be formed in a wave shape, instead of a straight line, between neighboring clusters (e.g., the first cluster C1 and the fourth cluster C4). In this case, the wires that connect the neighboring clusters (e.g., the first cluster C1 and the fourth cluster C4) and are disposed to overlap the second black mask BM2 may be formed to in a wave shape, instead of a straight line.

According to an embodiment, in the case where the second black mask BM2 is formed in a wave shape, instead of a straight line, between the neighboring clusters (e.g., the first cluster C1 and the fourth cluster C4), a virtual connection lines connecting the start and end points of the respective wire parts 1011, 1012, 1013, and 1014 of the second black mask BM2 may be irregular.

In FIG. 10, '1001' may represent a virtual first connection line connecting the start and end points of the first wire part 1011 of the second black mask BM2.

In FIG. 10, '1002' may represent a virtual second connection line connecting the start and end points of the second wire part 1012 of the second black mask BM2.

In FIG. 10, '1003' may represent a virtual third connection line connecting the start and end points of the third wire part 1013 of the third black mask BM3.

In FIG. 10, '1004' may represent a virtual fourth connection line connecting the start and end points of the fourth wire part 1014 of the fourth black mask BM4.

Based on the above definition, the first connection line 1001, the second connection line 1002, the third connection line 1003, and the fourth connection line 1004 according to an embodiment may have different tilted angles from each other with respect to a virtual reference axis (e.g., the Y axis).

According to an embodiment, the first connecting lines 1001 extending from the clusters in the same row may have irregular angles.

According to an embodiment, the second connecting lines 1002 extending from the clusters in the same row may have irregular angles.

According to an embodiment, the third connecting lines 1003 extending from the clusters in the same row may have irregular angles.

According to an embodiment, the fourth connecting lines 1004 extending from the clusters in the same row may have irregular angles.

According to various embodiments, the shape shown in FIG. 9 and the shape shown in FIG. 10 may be combined with each other.

According to various embodiments, since at least some of the boundary lines of the black mask 521 are formed in a wave shape, it is possible to reduce unintentional diffraction of light and improve the quality of images captured by the UDC (e.g., the camera 105 in FIG. 5).

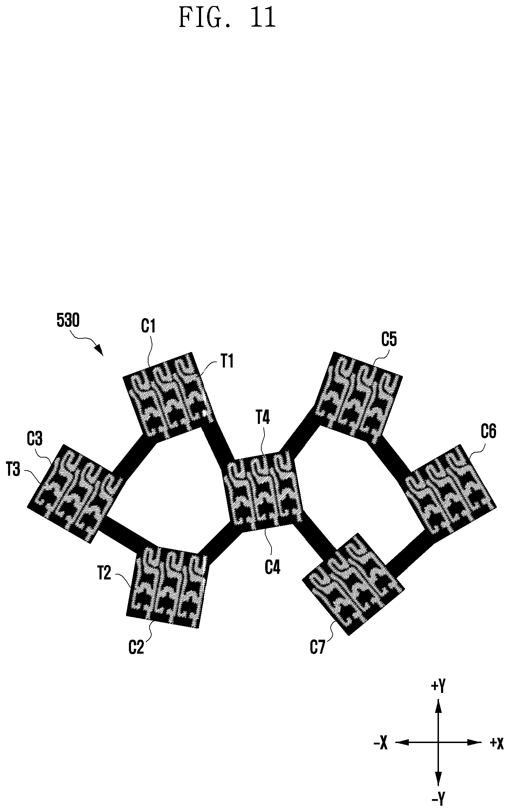

FIG. 11 may show an example of directions of TFTs according to an embodiment.

Referring to FIG. 11, a TFT for driving the first group of pixels 542 may be disposed in each of the first to fourth clusters C1, C2, C3, and C4 according to an embodiment. According to an embodiment, the TFT may be formed on the silicon layer 530 described with reference to FIG. 5.

According to an embodiment, TFTs T1, T2, T3, and T4 respectively formed in the first to fourth clusters C1, C2, C3, and C4 may be arranged in different directions from each other. For example, the TFTs T1, T2, T3, and T4 respectively formed in the first to fourth clusters C1, C2, C3, and C4 may be disposed to correspond to the tilted angles of the first to fourth clusters C1, C2, C3, and C4, respectively, based on the reference axis (e.g., the +Y axis).

According to an embodiment, at least one first TFT T1 disposed to overlap the first cluster C1 may be formed in the first direction because the boundary line of the first cluster C1 is formed in the first direction.

According to an embodiment, at least one second TFT T2 disposed to overlap the second cluster C2 may be formed in the second direction because the boundary line of the second cluster C2 is formed in the second direction.

According to an embodiment, at least one third TFT T3 disposed to overlap the third cluster C3 may be formed in the third direction because the boundary line of the third cluster C3 is formed in the third direction.

According to an embodiment, at least one fourth TFT T4 disposed to overlap the fourth cluster C4 may be formed in the fourth direction because the boundary line of the fourth cluster C4 is formed in the fourth direction.

According to various embodiments, since the TFTs T1, T2, T3, and T4 are formed in different directions from each other, it is possible to reduce unintentional diffraction of light and improve the quality of images captured by the UDC (e.g., the camera 105 in FIG. 5).

An electronic device (e.g., the electronic device 100 in FIG. 1) according to various embodiments may include a housing (e.g., the housing 110 in FIG. 1), a display (e.g., the display 400 in FIG. 4) that is visible through a portion of the housing 110, and a camera (e.g., the camera 105 in FIG. 3) disposed to overlap a portion of the display 400 and configured to obtain external light passing through the display 400, wherein the display 400 may include a first area (e.g., the first area A1 in FIG. 5) overlapping at least a portion of the camera 105 and a second area (e.g., the second area A2 in FIG. 5) excluding the first area A1, wherein the first area A1 may include a plurality of clusters (e.g., the plurality of clusters C1, C2, C3, C4, C5, C6, and C7) and at least one or more wires electrically connecting the plurality of clusters C1, C2, C3, C4, C5, C6, and C7 to each other, wherein a first sub-pixel (e.g., the first sub-pixel R1 in FIG. 6), a second sub-pixel (e.g., the second sub-pixel G1 in FIG. 6), and a third sub-pixel (e.g., the third sub-pixel B1 in FIG. 6) may be disposed adjacent to each other to form one cluster, wherein respective boundary lines of the plurality of clusters C1, C2, C3, C4, C5, C6, and C7 may be tilted at specific angles with respect to a designated reference axis, and wherein the tilted angles of the respective boundary lines of the plurality of clusters C1, C2, C3, C4, C5, C6, and C7 may be different from each other.

According to an embodiment, the plurality of clusters C1, C2, C3, C4, C5, C6, and C7 may be disposed in a matrix form such that clusters in odd-numbered rows and clusters in even-numbered rows are disposed to be staggered with each other, and a transmission area TA may be formed between the plurality of clusters C1, C2, C3, C4, C5, C6, and C7.

According to an embodiment, the plurality of clusters C1, C2, C3, C4, C5, C6, and C7 may include a first cluster C1 disposed in the +Y direction from the center of the transmission area, a second cluster C2 disposed in the -Y direction from the center of the transmission area, a third cluster C3 disposed in the +X direction from the center of the transmission area, and a fourth cluster C4 disposed in the -X direction from the center of the transmission area, and the +Y direction may form the reference axis.

According to an embodiment, the first cluster C1 may have a rectangular first boundary line disposed at a first angle with the +Y direction, the second cluster C2 may have a rectangular second boundary line disposed at a second angle, which is different from the first angle, with the +Y direction, the third cluster C3 may have a rectangular third boundary line disposed at a third angle, which is different from the first angle and the second angle, with the +Y direction, and the fourth cluster C4 may have a quadrangular fourth boundary line disposed at a fourth angle, which is different from the first to third angles, with the +Y direction.

According to an embodiment, the gap between the first cluster C1 and the second cluster C2 may have a first distance, and the gap between the wire connecting the first cluster C1 and the fourth cluster C4 to each other and the wire connecting the second cluster C2 and the third cluster C3 to each other may have a second distance, wherein the first distance and the second distance may be different.

According to an embodiment, the first area A1 may further include at least one or more TFTs disposed to overlap the plurality of clusters C1, C2, C3, C4, C5, C6, and C7, and the TFTs may be disposed to correspond to the tilted angles of the respective boundary lines of the plurality of clusters C1, C2, C3, C4, C5, C6, and C7.

According to an embodiment, as the boundary line of the first cluster C1 is formed in a first direction, at least one first TFT disposed to overlap the first cluster C1 may be formed in the first direction, as the boundary line of the second cluster C2 is formed in a second direction, at least one second TFT disposed to overlap the second cluster C2 may be formed in the first direction, as the boundary line of the third cluster C3 is formed in a third direction, at least one third TFT disposed to overlap the third cluster C3 may be formed in the third direction, and as the boundary line of the fourth cluster C4 is formed in a fourth direction, at least one fourth TFT disposed to overlap the fourth cluster C4 may be formed in the fourth direction.

According to an embodiment, the first area A1 may further include a black mask disposed to overlap the plurality of clusters C1, C2, C3, C4, C5, C6, and C7 and the at least one or more wires, wherein the black mask may include a first black mask BM1 overlapping the plurality of clusters C1, C2, C3, C4, C5, C6, and C7 and a second black mask BM2 overlapping the at least one or more wires, wherein the second black mask BM2 may include a first wire part 711 overlapping at least one first wire connecting the first cluster C1 and the third cluster C3, a second wire part 712 overlapping at least one second wire connecting the second cluster C2 and the third cluster C3, a third wire part 713 overlapping at least one third wire connecting the second cluster C2 and the fourth cluster C4, and a fourth wire part 714 overlapping at least one fourth wire connecting the first cluster C1 and the fourth cluster C4, and wherein, based on the reference axis, the tilt angles of the first wire part 711 to the fourth wire part 714 may be different from each other.

According to an embodiment, the tilted angles of the first wire parts 711 extending from the clusters disposed in the same row may be irregular, the tilted angles of the second wire parts 712 extending from the clusters disposed in the same row may be irregular, the tilted angles of the third wire parts 713 extending from the clusters disposed in the same row may be irregular, and the tilted angles of the fourth wire parts 714 extending from the clusters disposed in the same row may be irregular.

According to an embodiment, the boundary line of the first black mask BM1 may have a wave shape with a first curvature, and the boundary line of the second black mask BM2 may have a wave shape with a second curvature.

According to an embodiment, the first curvature and the second curvature may be different from each other.

According to an embodiment, the second black mask BM2 may be formed in a wave shape, instead of a straight line, and at least one or more wires overlapping at least a portion of the second black mask BM2 may be disposed in a wave shape to correspond to the shape of the second black mask BM2.

A display 400 for an under-display camera (UDC) (e.g., the camera 105 in FIG. 5) according to various embodiments may include a first area A1 overlapping at least a portion of the UDC 105 and a second area A2 excluding the first area A1, wherein the first area A1 may include a plurality of clusters C1, C2, C3, C4, C5, C6, and C7 and at least one or more wires electrically connecting the plurality of clusters C1, C2, C3, C4, C5, C6, and C7 to each other, wherein a first sub-pixel R1, a second sub-pixel G1, and a third sub-pixel B1 may be disposed adjacent to each other to form one cluster, wherein respective boundary lines of the plurality of clusters C1, C2, C3, C4, C5, C6, and C7 may be tilted at specific angles with respect to a designated reference axis, and wherein the tilted angles of the respective boundary lines of the plurality of clusters C1, C2, C3, C4, C5, C6, and C7 may be different from each other.

According to an embodiment, the plurality of clusters C1, C2, C3, C4, C5, C6, and C7 may be disposed in a matrix form such that clusters in odd-numbered rows and clusters in even-numbered rows are disposed to be staggered with each other, and a transmission area TA may be formed between the plurality of clusters C1, C2, C3, C4, C5, C6, and C7.

According to an embodiment, in the display 400, the plurality of clusters C1, C2, C3, C4, C5, C6, and C7 may include a first cluster C1 disposed in the +Y direction from the center of the transmission area, a second cluster C2 disposed in the -Y direction from the center of the transmission area, a third cluster C3 disposed in the +X direction from the center of the transmission area, and a fourth cluster C4 disposed in the -X direction from the center of the transmission area, and the +Y direction may form the reference axis.

According to an embodiment, the first cluster C1 may have a rectangular first boundary line disposed at a first angle with the +Y direction, the second cluster C2 may have a rectangular second boundary line disposed at a second angle, which is different from the first angle, with the +Y direction, the third cluster C3 may have a rectangular third boundary line disposed at a third angle, which is different from the first angle and the second angle, with the +Y direction, and the fourth cluster C4 may have a quadrangular fourth boundary line disposed at a fourth angle, which is different from the first to third angles, with the +Y direction.

According to an embodiment, the gap between the first cluster C1 and the second cluster C2 may have a first distance, and the gap between the wire connecting the first cluster C1 and the fourth cluster C4 to each other and the wire connecting the second cluster C2 and the third cluster C3 to each other may have a second distance, wherein the first distance and the second distance may be different.

According to an embodiment, the first area A1 may further include at least one or more TFTs disposed to overlap the plurality of clusters C1, C2, C3, C4, C5, C6, and C7, and the TFTs may be disposed to correspond to the tilted angles of the respective boundary lines of the plurality of clusters C1, C2, C3, C4, C5, C6, and C7.

According to an embodiment, as the boundary line of the first cluster C1 is formed in a first direction, at least one first TFT disposed to overlap the first cluster C1 may be formed in the first direction, as the boundary line of the second cluster C2 is formed in a second direction, at least one second TFT disposed to overlap the second cluster C2 may be formed in the first direction, as the boundary line of the third cluster C3 is formed in a third direction, at least one third TFT disposed to overlap the third cluster C3 may be formed in the third direction, and as the boundary line of the fourth cluster C4 is formed in a fourth direction, at least one fourth TFT disposed to overlap the fourth cluster C4 may be formed in the fourth direction.

According to an embodiment, the first area A1 may further include a black mask disposed to overlap the plurality of clusters C1, C2, C3, C4, C5, C6, and C7 and the at least one or more wires, wherein the black mask may include a first black mask BM1 overlapping the plurality of clusters C1, C2, C3, C4, C5, C6, and C7 and a second black mask BM2 overlapping the at least one or more wires, and wherein the boundary line of the first black mask BM1 may have a wave shape with a first curvature, and the boundary line of the second black mask BM2 may have a wave shape with a second curvature.

## Claims

1. An electronic device (100) comprising:
a housing (110);
a display (101) that is visible through a portion of the housing (110); and
a camera (105) disposed to overlap a portion of the display (101) and configured to obtain external light passing through the display (101),
wherein the display (101) comprises a first area overlapping at least a portion of the camera (105) and a second area excluding the first area,
wherein the first area comprises a plurality of clusters and a plurality of wires electrically connecting the plurality of clusters to each other,
wherein each of the clusters in the first area includes a first sub-pixel, a second sub-pixel, and a third sub-pixel disposed adjacent to each other,
wherein respective boundary lines of the plurality of clusters are tilted at specific angles with respect to a designated reference axis, and
wherein the tilted angles of the respective boundary lines of the plurality of clusters are different from each other.

2. The electronic device (100) of claim 1, wherein the plurality of clusters are disposed in a matrix form such that clusters in odd-numbered rows and clusters in even-numbered rows are disposed to be staggered with each other, and
wherein the first area includes a transmission area formed between the plurality of clusters.

3. The electronic device (100) of claim 2, wherein the first area comprises:
a first cluster disposed in the +Y direction from the center of the transmission area;
a second cluster disposed in the -Y direction from the center of the transmission area;
a third cluster disposed in the +X direction from the center of the transmission area; and
a fourth cluster disposed in the -X direction from the center of the transmission area, and
wherein the +Y direction forms the reference axis.

4. The electronic device (100) of claim 3, wherein the first cluster includes a rectangular first boundary line disposed at a first angle with the +Y direction,
wherein the second cluster includes a rectangular second boundary line disposed at a second angle, which is different from the first angle, with the +Y direction,
wherein the third cluster includes a rectangular third boundary line disposed at a third angle, which is different from the first angle and the second angle, with the +Y direction, and
wherein the fourth cluster includes a quadrangular fourth boundary line disposed at a fourth angle, which is different from the first to third angles, with the +Y direction.

5. The electronic device (100) of claim 3, wherein a first gap between the first cluster and the second cluster includes a first distance,
wherein a second gap between a wire connecting the first cluster and the fourth cluster to each other and a wire connecting the second cluster and the third cluster to each other includes a second distance, and
wherein the first distance and the second distance are different.

6. The electronic device (100) of claim 3, wherein the first area further comprises a plurality of thin film transistors, TFTs, disposed to overlap the plurality of clusters, and
wherein the TFTs are disposed to correspond to the tilted angles of the respective boundary lines of the plurality of clusters.

7. The electronic device (100) of claim 6, wherein, as the boundary line of the first cluster is formed in a first direction, at least one first TFT disposed to overlap the first cluster is formed in the first direction,
wherein, as the boundary line of the second cluster is formed in a second direction, at least one second TFT disposed to overlap the second cluster is formed in the first direction,
wherein, as the boundary line of the third cluster is formed in a third direction, at least one third TFT disposed to overlap the third cluster is formed in the third direction, and
wherein, as the boundary line of the fourth cluster is formed in a fourth direction, at least one fourth TFT disposed to overlap the fourth cluster is formed in the fourth direction.

8. The electronic device (100) of claim 3, wherein the first area further comprises a black mask disposed to overlap the plurality of clusters and the plurality of wires,
wherein the black mask comprises a first black mask overlapping the plurality of clusters and a second black mask overlapping the plurality of wires,
wherein the second black mask comprises:
a first wire part overlapping at least one first wire connecting the first cluster and the third cluster;
a second wire part overlapping at least one second wire connecting the second cluster and the third cluster;
a third wire part overlapping at least one third wire connecting the second cluster and the fourth cluster; and
a fourth wire part overlapping at least one fourth wire connecting the first cluster and the fourth cluster, and
wherein, based on the reference axis, the tilt angles of the first to fourth wire parts are different from each other.

9. The electronic device (100) of claim 8, wherein the tilted angles of the first wire parts extending from the clusters disposed in the same row are irregular,
wherein the tilted angles of the second wire parts extending from the clusters disposed in the same row are irregular,
wherein the tilted angles of the third wire parts extending from the clusters disposed in the same row are irregular, and
wherein the tilted angles of the fourth wire parts extending from the clusters disposed in the same row are irregular.

10. The electronic device (100) of claim 8, wherein the boundary line of the first black mask includes a wave shape with a first curvature, and
wherein the boundary line of the second black mask includes a wave shape with a second curvature.

11. The electronic device (100) of claim 10, wherein the first curvature and the second curvature are different from each other.

12. The electronic device (100) of claim 10, wherein the second black mask is formed in the wave shape, instead of a straight line, and
wherein the plurality of wires overlapping at least a portion of the second black mask are disposed in the wave shape to correspond to the shape of the second black mask.

## Patentansprüche

1. Elektronische Vorrichtung (100), umfassend:
ein Gehäuse (110);
eine Anzeige (101), die durch einen Abschnitt des Gehäuses (110) sichtbar ist; und
eine Kamera (105), die angeordnet ist, um einen Teil der Anzeige (101) zu überlappen, und konfiguriert ist, um externes Licht zu erhalten, das durch die Anzeige (101) tritt,
wobei die Anzeige (101) einen ersten Bereich, der mindestens einen Abschnitt der Kamera (105) überlappt, und einen zweiten Bereich mit Ausnahme des ersten Bereichs umfasst,
wobei der erste Bereich eine Vielzahl von Clustern und eine Vielzahl von Drähten umfasst, die die Vielzahl von Clustern elektrisch miteinander verbinden,
wobei jeder der Cluster in dem ersten Bereich ein erstes Subpixel, ein zweites Subpixel und ein drittes Subpixel beinhaltet, die benachbart zueinander angeordnet sind,
wobei jeweilige Grenzlinien der Vielzahl von Clustern in bestimmten Winkeln in Bezug auf eine spezifizierte Referenzachse geneigt sind, und
wobei sich die Neigungswinkel der jeweiligen Grenzlinien der Vielzahl von Clustern voneinander unterscheiden.

2. Elektronische Vorrichtung (100) nach Anspruch 1, wobei die Vielzahl von Clustern in einer Matrixform so angeordnet ist, dass Cluster in ungeradzahligen Reihen und Cluster in geradzahligen Reihen angeordnet sind, um zueinander versetzt zu sein, und
wobei der erste Bereich einen Übertragungsbereich beinhaltet, der zwischen der Vielzahl von Clustern gebildet ist.

3. Elektronische Vorrichtung (100) nach Anspruch 2, wobei der erste Bereich Folgendes umfasst:
ein erstes Cluster, das in der +Y-Richtung von der Mitte des Übertragungsbereichs angeordnet ist;
ein zweites Cluster, das in der -Y-Richtung von der Mitte des Übertragungsbereichs angeordnet ist;
ein drittes Cluster, das in der +X-Richtung von der Mitte des Übertragungsbereichs angeordnet ist; und
ein viertes Cluster, das in der -X-Richtung von der Mitte des Übertragungsbereichs angeordnet ist, und
wobei die +Y-Richtung die Referenzachse bildet.

4. Elektronische Vorrichtung (100) nach Anspruch 3, wobei der erste Cluster eine rechteckige erste Grenzlinie beinhaltet, die in einem ersten Winkel mit der +Y-Richtung angeordnet ist, wobei der zweite Cluster eine rechteckige zweite Grenzlinie beinhaltet, die in einem zweiten Winkel, der sich von dem ersten Winkel unterscheidet, mit der +Y-Richtung angeordnet ist,
wobei der dritte Cluster eine rechteckige dritte Grenzlinie umfasst, die in einem dritten Winkel, der sich von dem ersten Winkel und dem zweiten Winkel unterscheidet, mit der +Y-Richtung angeordnet ist, und
wobei der vierte Cluster eine viereckige vierte Begrenzungslinie beinhaltet, die in einem vierten Winkel, der sich von dem ersten bis dritten Winkel unterscheidet, mit der +Y-Richtung angeordnet ist.

5. Elektronische Vorrichtung (100) nach Anspruch 3, wobei eine erste Lücke zwischen dem ersten Cluster und dem zweiten Cluster einen ersten Abstand beinhaltet,
wobei eine zweite Lücke zwischen einem Draht, der den ersten Cluster und den vierten Cluster miteinander verbindet, und einem Draht, der den zweiten Cluster und den dritten Cluster miteinander verbindet, einen zweiten Abstand beinhaltet, und
wobei der erste Abstand und der zweite Abstand unterschiedlich sind.

6. Elektronische Vorrichtung (100) nach Anspruch 3, wobei der erste Bereich ferner eine Vielzahl von Dünnschichttransistoren, TFTs, umfasst, die angeordnet sind, um die Vielzahl von Clustern zu überlappen, und
wobei die TFTs angeordnet sind, um den Neigungswinkeln der jeweiligen Grenzlinien der Vielzahl von Clustern zu entsprechen.

7. Elektronische Vorrichtung (100) nach Anspruch 6, wobei, wenn die Grenzlinie des ersten Clusters in einer ersten Richtung gebildet wird, mindestens ein erster TFT, der angeordnet ist, um das erste Cluster zu überlappen, in der ersten Richtung gebildet wird,
wobei, wenn die Grenzlinie des zweiten Clusters in einer zweiten Richtung gebildet wird, mindestens ein zweiter TFT, der angeordnet ist, um das zweite Cluster zu überlappen, in der ersten Richtung gebildet wird,
wobei, wenn die Grenzlinie des dritten Clusters in einer dritten Richtung gebildet wird, mindestens ein dritter TFT, der angeordnet ist, um den dritten Cluster zu überlappen, in der dritten Richtung gebildet wird, und
wobei, wenn die Grenzlinie des vierten Clusters in einer vierten Richtung gebildet wird, mindestens ein vierter TFT, der angeordnet ist, um den vierten Cluster zu überlappen, in der vierten Richtung gebildet wird.

8. Elektronische Vorrichtung (100) nach Anspruch 3, wobei der erste Bereich ferner eine schwarze Maske umfasst, die angeordnet ist, um die Vielzahl von Clustern und die Vielzahl von Drähten zu überlappen,
wobei die schwarze Maske eine erste schwarze Maske, die die Vielzahl von Clustern überlappt, und eine zweite schwarze Maske, die die Vielzahl von Drähten überlappt, umfasst, wobei die zweite schwarze Maske Folgendes umfasst:
einen ersten Drahtteil, der mindestens einen ersten Draht, der den ersten Cluster und den dritten Cluster verbindet, überlappt;
einen zweiten Drahtteil, der mindestens einen zweiten Draht, der den zweiten Cluster und den dritten Cluster verbindet, überlappt;
einen dritten Drahtteil, der mindestens einen dritten Draht, der den zweiten Cluster und den vierten Cluster verbindet, überlappt; und
einen vierten Drahtteil, der mindestens einen vierten Draht, der den ersten Cluster und den vierten Cluster verbindet, überlappt, und
wobei sich, basierend auf der Referenzachse, die Neigungswinkel des ersten bis vierten Drahtteils voneinander unterscheiden.

9. Elektronische Vorrichtung (100) nach Anspruch 8, wobei die Neigungswinkel der ersten Drahtteile, die sich von den in derselben Reihe angeordneten Clustern erstrecken, unregelmäßig sind, wobei die Neigungswinkel der zweiten Drahtteile, die sich von den in derselben Reihe angeordneten Clustern erstrecken, unregelmäßig sind,
wobei die Neigungswinkel der dritten Drahtteile, die sich von den in derselben Reihe angeordneten Clustern erstrecken, unregelmäßig sind, und
wobei die Neigungswinkel der vierten Drahtteile, die sich von den in derselben Reihe angeordneten Clustern erstrecken, unregelmäßig sind.

10. Elektronische Vorrichtung (100) nach Anspruch 8, wobei die Grenzlinie der ersten schwarzen Maske eine Wellenform mit einer ersten Krümmung beinhaltet, und
wobei die Grenzlinie der zweiten schwarzen Maske eine Wellenform mit einer zweiten Krümmung beinhaltet.

11. Elektronische Vorrichtung (100) nach Anspruch 10, wobei sich die erste Krümmung und die zweite Krümmung voneinander unterscheiden.

12. Elektronische Vorrichtung (100) nach Anspruch 10, wobei die zweite schwarze Maske in der Wellenform anstelle einer geraden Linie gebildet ist, und
wobei die Vielzahl von Drähten, die zumindest einen Abschnitt der zweiten schwarzen Maske überlappen, in der Wellenform angeordnet sind, um der Form der zweiten schwarzen Maske zu entsprechen.

## Revendications

1. Dispositif électronique (100) comprenant :
un boîtier (110) ;
un affichage (101) qui est visible à travers une partie du boîtier (110) ; et
une caméra (105) disposée pour chevaucher une partie de l'affichage (101) et configurée pour obtenir une lumière externe traversant l'affichage (101),
dans lequel l'affichage (101) comprend une première zone chevauchant au moins une partie de la caméra (105) et une seconde zone excluant la première zone,
dans lequel la première zone comprend une pluralité de groupes et une pluralité de fils connectant électriquement la pluralité de groupes les uns aux autres,
dans lequel chacun des groupes dans la première zone comprend un premier sous-pixel, un deuxième sous-pixel et un troisième sous-pixel disposés adjacents l'un à l'autre,
dans lequel les lignes de délimitation respectives de la pluralité de groupes sont inclinées à des angles spécifiques par rapport à un axe de référence désigné, et
dans lequel les angles d'inclinaison des lignes de délimitation respectives de la pluralité de groupes sont différents les uns des autres.

2. Dispositif électronique (100) selon la revendication 1, dans lequel la pluralité de groupes sont disposés sous forme de matrice de sorte que les groupes de rangées impaires et les groupes de rangées paires soient disposés en décalage les uns des autres, et
dans lequel la première zone comprend une zone de transmission formée entre la pluralité de groupes.

3. Dispositif électronique (100) selon la revendication 2, dans lequel la première zone comprend :
un premier groupe disposé dans la direction +Y à partir du centre de la zone de transmission ;
un deuxième groupe disposé dans la direction -Y à partir du centre de la zone de transmission ;
un troisième groupe disposé dans la direction +X à partir du centre de la zone de transmission ; et
un quatrième groupe disposé dans la direction -X à partir du centre de la zone de transmission, et
dans lequel la direction +Y forme l'axe de référence.

4. Dispositif électronique (100) selon la revendication 3, dans lequel le premier groupe comprend une première ligne de délimitation rectangulaire disposée à un premier angle avec la direction +Y,
dans lequel le deuxième groupe comprend une deuxième ligne de délimitation rectangulaire disposée à un deuxième angle, qui est différent du premier angle, avec la direction +Y,
dans lequel le troisième groupe comprend une troisième ligne de délimitation rectangulaire disposée à un troisième angle, qui est différent du premier angle et du deuxième angle, avec la direction +Y, et
dans lequel le quatrième groupe comprend une quatrième ligne de délimitation quadrangulaire disposée à un quatrième angle, qui est différent des premier au troisième angles, avec la direction +Y.

5. Dispositif électronique (100) selon la revendication 3, dans lequel un premier espace entre le premier groupe et le deuxième groupe comprend une première distance,
dans lequel un deuxième espace entre un fil reliant le premier groupe et le quatrième groupe l'un à l'autre et un fil reliant le deuxième groupe et le troisième groupe l'un à l'autre comprend une deuxième distance, et
dans lequel la première distance et la deuxième distance sont différentes.

6. Dispositif électronique (100) selon la revendication 3, dans lequel la première zone comprend en outre une pluralité de transistors en couches minces, TFT, disposés pour chevaucher la pluralité de groupes, et
dans lequel les TFT sont disposés pour correspondre aux angles inclinés des lignes de délimitation respectives de la pluralité de groupes.

7. Dispositif électronique (100) selon la revendication 6, dans lequel, lorsque la ligne de délimitation du premier groupe est formée dans une première direction, au moins un premier TFT disposé pour chevaucher le premier groupe est formé dans la première direction,
dans lequel, lorsque la ligne de délimitation du deuxième groupe est formée dans une deuxième direction, au moins un deuxième TFT disposé pour chevaucher le deuxième groupe est formé dans la première direction,
dans lequel, lorsque la ligne de délimitation du troisième groupe est formée dans une troisième direction, au moins un troisième TFT disposé pour chevaucher le troisième groupe est formé dans la troisième direction, et
dans lequel, lorsque la ligne de délimitation du quatrième groupe est formée dans une quatrième direction, au moins un quatrième TFT disposé pour chevaucher le quatrième groupe est formé dans la quatrième direction.

8. Dispositif électronique (100) selon la revendication 3, dans lequel la première zone comprend en outre un masque noir disposé pour chevaucher la pluralité de groupes et la pluralité de fils,
dans lequel le masque noir comprend un premier masque noir chevauchant la pluralité de groupes et un second masque noir chevauchant la pluralité de fils,
dans lequel le second masque noir comprend :
une première partie de fil chevauchant au moins un premier fil reliant le premier groupe et le troisième groupe ;
une deuxième partie de fil chevauchant au moins un deuxième fil reliant le deuxième groupe et le troisième groupe ;
une troisième partie de fil chevauchant au moins un troisième fil reliant le deuxième groupe et le quatrième groupe ; et
une quatrième partie de fil chevauchant au moins un quatrième fil reliant le premier groupe et le quatrième groupe, et
dans lequel, sur la base de l'axe de référence, les angles d'inclinaison des première à quatrième parties de fil sont différents les uns des autres.

9. Dispositif électronique (100) selon la revendication 8, dans lequel les angles d'inclinaison des premières parties de fil s'étendant à partir des groupes disposés dans la même rangée sont irréguliers,
dans lequel les angles d'inclinaison des secondes parties de fil s'étendant à partir des groupes disposés dans la même rangée sont irréguliers,
dans lequel les angles d'inclinaison des troisièmes parties de fil s'étendant à partir des groupes disposés dans la même rangée sont irréguliers, et
dans lequel les angles d'inclinaison des quatrièmes parties de fil s'étendant à partir des groupes disposés dans la même rangée sont irréguliers.

10. Dispositif électronique (100) selon la revendication 8, dans lequel la ligne de délimitation du premier masque noir comprend une forme d'onde avec une première courbure, et
dans lequel la ligne de délimitation du second masque noir comprend une forme d'onde avec une seconde courbure.

11. Dispositif électronique (100) selon la revendication 10, dans lequel la première courbure et la seconde courbure sont différentes l'une de l'autre.

12. Dispositif électronique (100) selon la revendication 10, dans lequel le second masque noir est formé en forme d'onde, au lieu d'une ligne droite, et
dans lequel la pluralité de fils chevauchant au moins une partie du second masque noir sont disposés dans la forme d'onde pour correspondre à la forme du second masque noir.
